# EUROPÄISCHE PATENTANMELDUNG

(11) **EP 3 168 633 A2**
(43) Veröffentlichungstag der Anmeldung: **17.05.2017**
(21) Anmeldenummer: 16188073.7
(22) Anmeldetag: 09.09.2016
(51) Int. Cl.: G01R 33/00, G01R 33/02

(54) **SENSORVORRICHTUNG, DREIDIMENSIONALE SENSORVORRICHTUNG UND ENTSPRECHENDES HERSTELLUNGSVERFAHREN FÜR EINE SENSORVORRICHTUNG**

(30) Priorität: 12.11.2015 DE 102015222344
(71) Anmelder: ROBERT BOSCH GMBH, 70442 Stuttgart (DE)
(72) Erfinder: Rohlfing, Franziska, 71229 Leonberg (DE); Heuck, Friedjof, 70193 Stuttgart (DE)

(57) **Zusammenfassung**

Die Erfindung schafft eine Sensorvorrichtung, eine dreidimensionale Sensorvorrichtung und ein entsprechendes Herstellungsverfahren.

Die Sensorvorrichtung (Hx1) umfasst ein Halbleitersubstrat (10), das eine Kavität (K1) umfasst, wobei die Kavität (K1) eine Oberseite (O1), eine Bodenfläche (B1), eine erste Seitenfläche (F1), eine zweite Seitenfläche (F2), eine dritte Seitenfläche (F3) und eine vierte Seitenfläche (F4) umfasst, wobei die erste Seitenfläche (F1) der zweiten Seitenfläche (F2) gegenüberliegt und die dritte Seitenfläche (F3) der vierten Seitenfläche (F4) gegenüberliegt. Die Oberseite (O1) der Kavität (K1) weist an der ersten Seitenfläche (F1) zumindest bereichsweise zwei Stromzuführbereiche (S1, S2) und einen ersten Hallspannungsbereich (UH1) auf, wobei der erste Hallspannungsbereich (UH1) zwischen den zwei Stromzuführbereichen (S1, S2) angeordnet ist und an der Oberseite (O1) der zweiten Seitenfläche (F2) ein zweiter Hallspannungsbereich (UH2) angeordnet ist und eine zumindest bereichsweise homogene Kohlenstoffschicht (70) der dritten Seitenfläche (F3) und der vierten Seitenfläche (F4) durchbrochen ist und der ersten Hallspannungsbereich (UH1) mit dem zweiten Hallspannungsbereich (UH2) mittels der zumindest bereichsweisen homogenen Kohlenstoffschicht (70) verbunden ist.

## Beschreibung

Die vorliegende Erfindung betrifft eine Sensorvorrichtung, eine dreidimensionale Sensorvorrichtung und ein Herstellungsverfahren für eine Sensorvorrichtung.

### Stand der Technik

Um ein Magnetfeld messen zu können, kann insbesondere eine Sensorvorrichtung eingesetzt werden, welche den Hall-Effekt nutzt. Hierbei kann das Magnetfeld in einer Richtung eines orthogonalen Koordinatensystems, beispielsweise X-Richtung gemessen werden. Um Magnetfelder in allen drei Raumrichtungen (X-, Y-, Z-Richtung) messen zu können, benötigt man drei Sensorvorrichtungen, die derart zueinander angeordnet sind, dass sie die drei senkrechten Komponenten der jeweiligen Richtungen getrennt messen. Mit anderen Worten werden die Magnetfelder in einem definierten Winkel der einzelnen Komponenten gemessen, aus denen die senkrechten Beiträge berechnet werden können.

Ein Hall-Sensor basierend auf einem Halbleiterbauelement bietet sich aufgrund seiner einfachen Ausführung - da insbesondere keine Metallspulen benötigt werden - als Sensorvorrichtung an. Um beispielsweise einen dreidimensionalen Hall-Sensor bereitzustellen, bedient man sich aufwändiger Aufbau- und Verbindungstechniken. Mit anderen Worten werden die Sensorvorrichtungen aufwendig einzeln hergestellt und anschließend mittels beispielsweise Wafer-Bond-Verfahren miteinander kontaktiert. Mittels planarer Wafertechnik kann über eine aufwändige Aufbau- und Verbindungstechnik, mittels Magnetfeldkonzentrationen, die parallelen Magnetfeldkomponenten in senkrechte Magnetfeldkomponenten umgewandelt und danach mit einem Hall-Sensor gemessen werden.

Auf Waferlevel ist es allerdings schwierig, Hall-Sensoren für die einzelnen Magnetfeldkomponenten bereitzustellen.

Die WO 2014/114401 A1 beschreibt einen zusammengesetzten Hall-Sensor.

### Offenbarung der Erfindung

Die vorliegende Erfindung schafft eine Sensorvorrichtung zum Messen eines Magnetfeldes nach Anspruch 1, eine dreidimensionale Sensorvorrichtung nach Anspruch 4 und ein entsprechendes Herstellungsverfahren nach Anspruch 5.

Bevorzugte Weiterbildungen sind Gegenstand der jeweiligen Unteransprüche.

### Vorteile der Erfindung

Die vorliegende Erfindung ermöglicht es insbesondere, die dreidimensionale Sensorvorrichtung auf Waferlevel kostensparend herzustellen. Hierzu werden drei Sensorvorrichtungen nach Anspruch 1 auf Waferlevel derart verschaltet, dass die Magnetfelder in X-Richtung, Y-Richtung und/oder Z-Richtung gemessen werden können. Mit anderen Worten kann eine dreidimensionale Sensorvorrichtung bereitgestellt werden, die drei räumlich unabhängige Magnetfeldkomponenten getrennt voneinander bestimmen kann ohne auf aufwendige Aufbau- und Verbindungstechniken zurückzugreifen.

Hierzu wird insbesondere von der Idee Gebrauch gemacht, die homogene Kohlenstoffschicht selektiv auf Siliziumoxid abzuscheiden. Mit anderen Worten erfolgt während des Herstellungsverfahrens ein selektives Aufwachsen an allen freiliegenden Siliziumoxidschichten der Sensorvorrichtung und der dreidimensionalen Sensorvorrichtung.

Unter Siliziumoxid wird vorliegend insbesondere Siliziumdioxid verstanden.

Unter der hier beschriebenen Sensorvorrichtung kann insbesondere ein Hall-Sensor verstanden werden.

Das hier beschriebene Halbleitersubstrat kann insbesondere in Form eines Siliziumwafers vorliegen.

Die Kohlenstoffschicht kann insbesondere Graphen umfassen. Die Kohlenstoffschicht wächst insbesondere an oxidierten oder thermisch oxidierten Siliziumoberflächen des Halbleitersubstrats und/oder der Siliziumoxidschicht auf. Die Kohlenstoffschicht wächst hierbei nicht auf Silizium- bzw. Siliziumcarbid (SiC)-Oberflächen auf. Hierbei wurde überraschenderweise festgestellt, dass die Kohlenstoffschicht insbesondere an quer bzw. senkrecht zur Waferoberfläche stehenden Seitenwänden oder Seitenflächen von beispielsweise Ausnehmungen, Kavitäten, Vertiefungen bzw. Trench-Gräben als homogene Schicht aufwächst.

Aufgrund dieser Eigenschaft ist es möglich, auf Basis des Halbleitersubstrats die Sensorvorrichtung bzw. die dreidimensionale Sensorvorrichtung auf Waferlevel bereitzustellen. Insbesondere kann basierend auf dem hier beschriebenen Herstellungsverfahren eine dreidimensionale Sensorvorrichtung, die den Hall-Effekt nutzt, bereitgestellt werden, wobei zwei der Sensorvorrichtungen an den Seitenflächen der geätzten Kavitäten aufgebracht werden und die dritte Sensorvorrichtung parallel zur Oberfläche des Halbleitersubstrats. Somit können durch einfache Anordnung die Magnetfelder in allen drei Raumrichtungen getrennt voneinander gemessen werden. Dies erlaubt einen kostengünstigen Aufbau für dreidimensionale Sensorvorrichtungen ohne auf aufwändige Aufbau- und Verbindungstechniken zurückzugreifen.

Ferner ist in Abhängigkeit materialspezifischer Eigenschaften der Kohlenstoffschicht die Messung eines Magnetfeldes mit geringer Leistungsaufnahme möglich, da das Hall-Signal bei gleichem Strom deutlich stärker ist, als bei Hall-Sensoren mit klassischen Halbleitern, beispielsweise Silizium. Daher ist eine Reduktion eines Stromes und einer Leistungsaufnahme möglich. Zusätzlich hat die Magnetfeldmessung mittels Hall-Effekt den Vorteil eines linearen Ausgangssignals, welcher bei einem magnetischen Tunnelwiderstand (TMR) nicht messbar ist.

Gemäß einer bevorzugten Weiterbildung umfasst die homogene Kohlenstoffschicht ein ausschließlich auf Siliziumoxid selektiv aufwachsbares Graphen. So lassen sich auf Waferlevel mittels des Siliziumoxids Bereiche definieren, auf denen die Graphen-Schicht abgeschieden oder aufgewachsen werden kann. Die Kohlenstoffschicht kann eine leitende Kohlenstoffschicht sein.

Gemäß einer weiteren bevorzugten Weiterbildung sind auf Flächen der Sensorvorrichtung, die frei von der homogen Kohlenstoffschicht sind, zumindest bereichsweise Siliziumcarbid aufgewachsen. Das hier beschriebene Siliziumcarbid kann die leitenden Bereiche, auf welchen die homogene Kohlenstoffschicht aufgewachsen ist, voneinander isolieren. Insbesondere wächst das Siliziumcarbid nicht auf Siliziumoxid oder Siliziumdioxid auf. So lässt sich das Siliziumcarbid besonders einfach zwischen den Bereichen, welche die homogene Kohlenstoffschicht umfassen, aufwachsen.

Gemäß einer weiteren bevorzugten Weiterbildung werden mittels einer Schattenmaske Metallkontakte zum Kontaktieren der Stromzuführbereiche auf der Kohlenstoffschicht angeordnet. So lassen sich die Stromzuführbereiche einfach von außen kontaktieren.

Gemäß einer bevorzugten Weiterbildung umfasst die Siliziumoxidschicht eine Dicke von 2,5 Mikrometer. So lässt sich sicherstellen, dass die Siliziumoxidschicht einem Ätzschritt zum Entfernen von dünneren beispielsweisen Siliziumoxidschichten standhält.

Gemäß einer weiteren bevorzugten Weiterbildung umfasst die Siliziumcarbidschicht aus Schritt C eine Dicke von 500 Nanometer. So lässt sich die Siliziumcarbidschicht insbesondere zum Unterstützen der Maske während des Ätzens der Kavität einsetzen.

Gemäß einer weiteren bevorzugten Weiterbildung umfasst die Siliziumnitridschicht aus Schritt F eine Dicke von 300 Nanometer. So lässt sich das unter der Siliziumnitridschicht vorhandene Silizium besonders zeitsparend entfernen.

Gemäß einer weiteren bevorzugten Weiterbildung umfasst die Kohlenstoffschicht ein selektiv ausschließlich an Siliziumoxid aufwachsendes Graphen. So lassen sich die Bereiche mit dem Graphen insbesondere vor äußeren Einflüssen schützen.

Gemäß einer weiteren bevorzugten Weiterbildung umfasst die weitere Siliziumoxidschicht der Kavität eine Dicke von 1 Mikrometer. So lassen sich insbesondere die freistehenden Seitenflächen bzw. Seitenwände in der Kavität ausbilden.

Gemäß einer weiteren bevorzugten Weiterbildung wird das Ätzen mittels reaktiven lonentiefätzen durchgeführt. So lässt sich auf einfache Art und Weise ein gezieltes bereichsweises oder lokales Entfernen von hier beschrieben Schichten realisieren.

Die hier beschriebenen Merkmale der Sensorvorrichtung gelten auch für die dreidimensionale Sensorvorrichtung als auch für das Herstellungsverfahren für eine Sensorvorrichtung sowie umgekehrt.

### Kurze Beschreibung der Zeichnungen

Weitere Merkmale und Vorteile der vorliegenden Erfindung werden nachfolgend anhand von Ausführungsformen mit Bezug auf die Figuren erläutert.

Es zeigen:
- Fig. 1a: eine schematische Aufsicht zum Erläutern einer Sensorvorrichtung und eines entsprechenden Herstellungsverfahrens gemäß einer ersten Ausführungsform der vorliegenden Erfindung;
- Fig. 1b: eine schematische seitliche Querschnittsansicht der Fig. 1a;
- Fig. 2: eine schematische Aufsicht zum Erläutern einer Sensorvorrichtung zum Messen eines Magnetfeldes in X-Richtung;
- Fig. 3a - 3k: schematische Aufsichten und entsprechende schematische senkrechte Querschnittsansichten zum Erläutern einzelner Schritte eines Herstellungsverfahrens für eine Sensorvorrichtung;
- Fig. 4a - 4c: schematische Darstellungen eines Auswerteverfahrens;
- Fig. 5: schematische Darstellung eines alternativen Auswerteverfahrens;
- Fig. 6: ein Flussdiagramm zum Erläutern eines Herstellungsverfahrens für eine Sensorvorrichtung gemäß einer Ausführungsform der vorliegenden Erfindung; und
- Fig. 7: eine schematische Aufsicht zum Erläutern einer dreidimensionalen Sensorvorrichtung gemäß einer Ausführungsform der vorliegenden Erfindung.

### Ausführungsformen der Erfindung

In den Figuren bezeichnen gleiche Bezugszeichen gleiche bzw. funktionsgleiche Elemente.

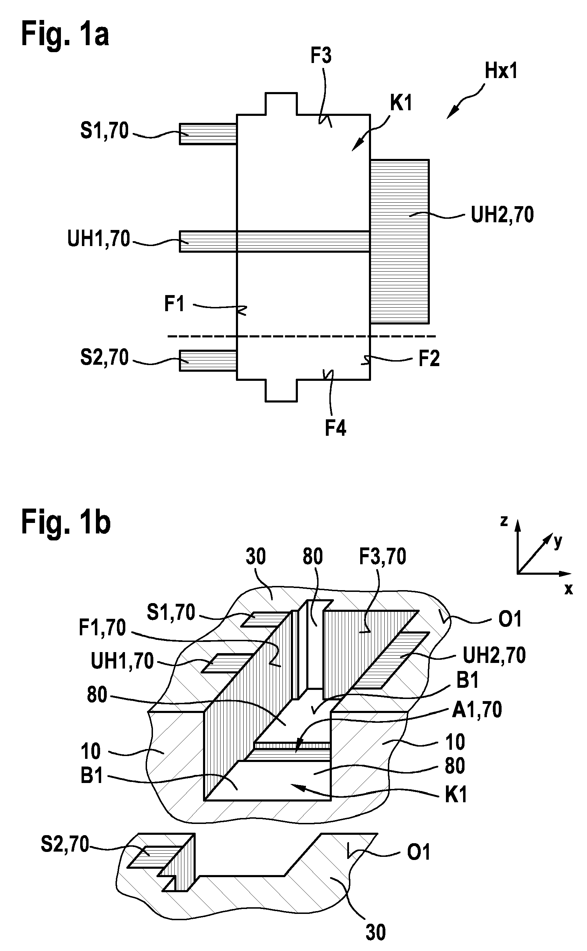

Fig. 1a zeigt eine schematische Aufsicht zum Erläutern einer Sensorvorrichtung und eines entsprechenden Herstellungsverfahrens gemäß einer ersten Ausführungsform der vorliegenden Erfindung.

In Fig. 1a bezeichnet Bezugszeichen Hx1 eine Sensorvorrichtung zum Messen eines Magnetfeldes in der X-Richtung. Die Fig. 1b zeigt eine senkrechte schematische Querschnittsansicht entlang der gestrichelten Linie der Figur 1a.

Das Bezugszeichen 10 bezeichnet hierbei das Halbleitersubstrat, das eine Kavität K1 umfasst. Die Kavität umfasst eine Oberseite O1, eine Bodenfläche B1, eine erste Seitenfläche F1, eine zweite Seitenfläche F2, eine dritte Seitenfläche F3 und eine vierte Seitenfläche F4, wobei die erste Seitenfläche F1 der zweiten Seitenfläche F2 gegenüberliegt und die dritte Seitenfläche F3 der vierten Seitenfläche F4 gegenüberliegt.

Die Oberseite O1 der Kavität K1 weist an der ersten Seitenfläche F1 zumindest bereichsweise zwei Stromzuführbereiche S1, S2 und einen ersten Hallspannungsbereich UH1 auf, wobei der erste Hallspannungsbereich UH1 zwischen den zwei Stromzuführbereichen S1, S2 angeordnet ist. Ferner ist an der Oberseite O1 der zweiten Seitenfläche F2 ein zweiter Hallspannungsbereich UH2 angeordnet. Wie in der Fig. 1a gezeigt kann der zweite Hallspannungsbereich UH2 dem ersten Hallspannungsbereich UH1 gegenüberliegend an der Oberseite O1 der Kavität K1 angeordnet sein.

Die Bodenfläche B1 der Kavität K1 weist wiederum eine Ausnehmung A1 auf, die zwischen der ersten Seitenfläche F1 und der zweiten Seitenfläche F2 durchgehend ausgebildet ist. Eine homogene Kohlenstoffschicht 70 ist wie in den Fig. 1a und Fig. 1b gezeigt auf der ersten, zweiten, dritten und vierten Seitenfläche F1, F2, F3, F4, der Ausnehmung A1, der zwei Stromzuführbereiche S1, S2, dem ersten Hallspannungsbereich UH1 und dem zweiten Hallspannungsbereich UH2 angeordnet.

Die homogene Kohlenstoffschicht 70 der dritten Seitenfläche F3 und der vierten Seitenfläche F4 ist durchbrochen und der erste Hallspannungsbereich UH1 ist mit dem zweiten Hallspannungsbereich UH2 mittels der homogenen Kohlenstoffschicht 70 verbunden, wobei die Ausnehmung A1 als Kontaktbrücke fungiert.

Bereiche der Sensorvorrichtung Hx1, die frei von der homogenen Kohlenstoffschicht 70 sind, weisen zumindest bereichsweise Siliziumcarbid 30, 80 auf. Das hier beschriebene Siliziumcarbid 30, 80 kann insbesondere als elektrische Isolation fungieren.

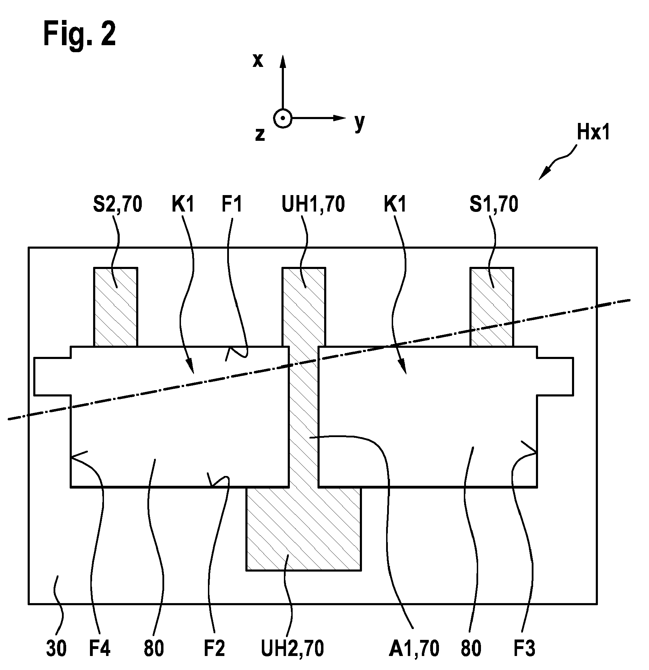

Fig. 2 zeigt eine schematische Aufsicht zum Erläutern einer Sensorvorrichtung zum Messen eines Magnetfeldes in X-Richtung.

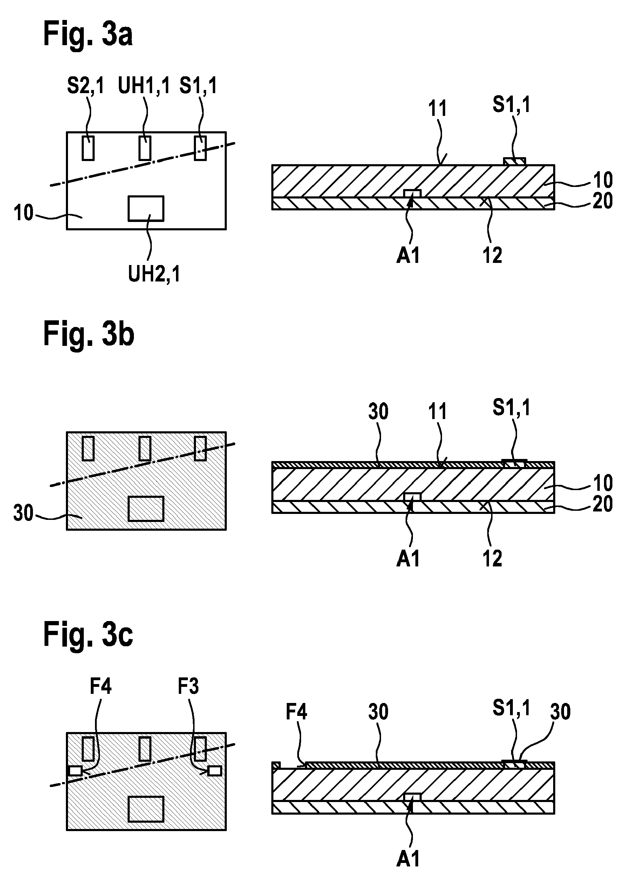

Die Fig. 2 zeigt eine Sensorvorrichtung Hx1, welche mittels der im Folgenden beschriebenen Schritte eines entsprechenden Verfahrens hergestellt worden sein kann. Die gestrichelte Linie der Fig. 2 kennzeichnet jeweils eine entsprechende Schnittebene der in den Fig. 3a - 3k gezeigten schematischen Querschnittsansichten der Sensorvorrichtung Hx1.

Fig. 3a bis 3k zeigen schematische Aufsichten und entsprechende schematische senkrechte Querschnittsansichten zum Erläutern einzelner Schritte eines Herstellungsverfahrens für eine Sensorvorrichtung.

Die Fig. 3a bis 3k zeigen ein Herstellungsverfahren für eine in der Fig. 1a und 1b gezeigte Sensorvorrichtung Hx1. Im Schritt A des Verfahrens wird ein Halbleitersubstrat 10 mit einer Vorderseite 11 und einer Rückseite 12 bereitgestellt, wobei auf der Rückseite 12 des Halbleitersubstrats 10 eine Ausnehmung A1 angeordnet ist. Ferner wird in einem Schritt B eine Siliziumoxidschicht 20 bereitgestellt, wobei das Halbleitersubstrat 10 mit seiner Rückseite 12 auf der Siliziumoxidschicht 20 angeordnet und somit die Siliziumoxidschicht 20 die Ausnehmung A1 bedeckt. Das hier beschriebene Halbleitersubstrat 10 mit der Siliziumoxidschicht 20 kann auf einem SOI-Wafer (Silicon on Insulator-Wafer) basieren. Das Halbleitersubstrat 10 kann hierbei eine Dicke von 50 bis 500 Mikrometer umfassen und die Ausnehmung A1 eine Tiefe von 1 Mikrometer bis 20 Mikrometer aufweisen.

Die Siliziumoxidschicht 20 kann insbesondere zwischen dem Halbleitersubstrat 10 und einem Trägerwafer (in der Fig. 3a nicht gezeigt) angeordnet sein. Die Dicke des Halbleitersubstrats 10 bestimmt neben einer vertikalen Ausdehnung der ausgebildeten Kavität K1, insbesondere eine Ausdehnung der Seitenflächen F1, F2 der herzustellenden Sensorvorrichtung Hx1 und damit dessen Rauschverhalten. Außerdem gehen die entsprechenden Flächen bei einer angelegten Spannung über die Drude-Gleichung für einen Strom linear in die Hall-Spannung ein.

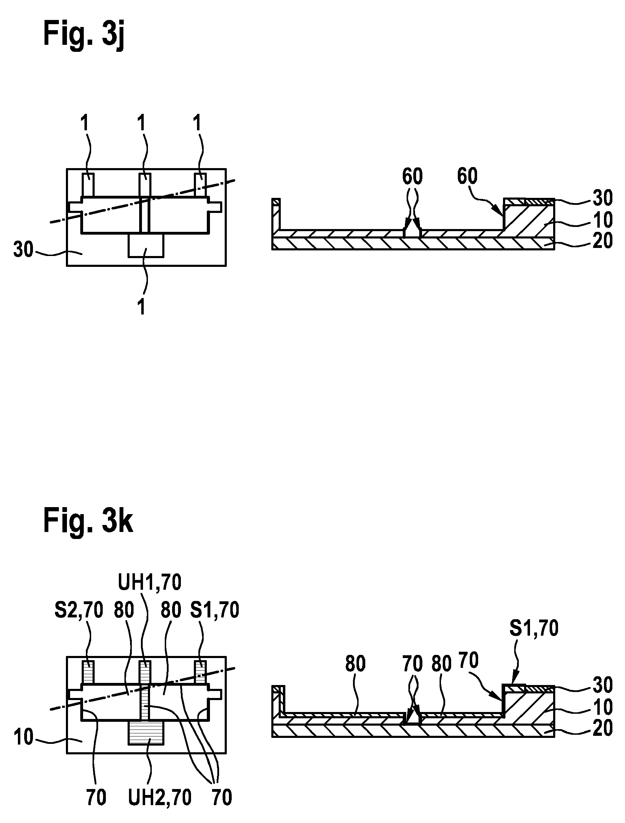

Im dargestellten Schritt C der Fig. 3a wird das Halbleitersubstrat 10 zum Ausbilden einer Siliziumoxidschicht 1 thermisch oxidiert und die Siliziumoxidschicht 1 derart strukturiert, dass sich zwei Stromzuführbereiche S1, S2 und zwei Hallspannungsbereiche UH1, UH2 zur Inbetriebnahme der Sensorvorrichtung Hx1 nach Schritt L, wie in der Aufsicht der Fig. 3a bzw. Fig. 3k gezeigt, ausbilden. Die Siliziumoxidschicht 1 kann hierbei eine Dicke von 2,5 Mikrometer umfassen.

Im dargestellten Schritt D der Fig. 3b wird auf einer der Rückseite 12 des Halbleitersubstrats 10 abgewandten Fläche ganzflächig eine Siliziumcarbidschicht 30 aufgebracht. Die Siliziumcarbidschicht 30 kann eine Dicke von 500 Nanometer umfassen.

Im dargestellten Schritt E der Fig. 3c wird die Siliziumcarbidschicht 30 derart strukturiert, dass miteinander elektrisch in Kontakt stehende Seitenflächen F3, F4, wie in der Fig. 3j gezeigt, später getrennt werden können (siehe Fig. 3j; Schritt K) und somit das Halbleitersubstrat 10 zumindest bereichsweise freigelegt wird.

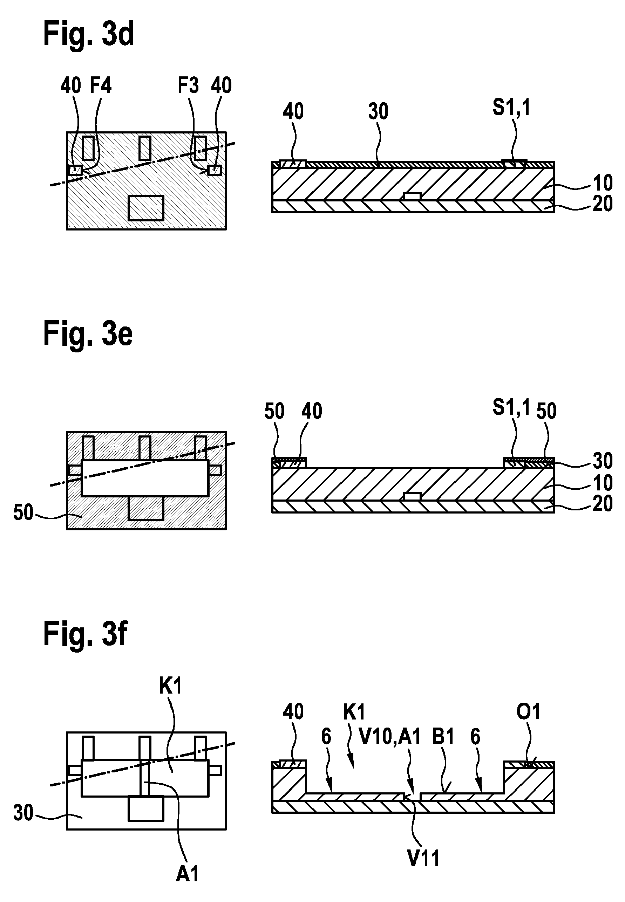

Im dargestellten Schritt F der Fig. 3d wird eine Siliziumnitridschicht 40 ganzflächig abgeschieden und danach strukturiert, so dass die zumindest bereichsweise freiliegenden Flächen des Halbleitersubstrats 10 mit der Siliziumnitridschicht 40 bedeckt werden. Dies erfolgt um die freigelegten Flächen des Halbleitersubstrats 10 im vorangegangenen Verfahrensschritt gegen Oxidation zu schützen. Nach dem in der Fig. 3f gezeigten Schritt liegt an der Vorderseite 11 des Halbleitersubstrats 10 kein Silizium frei.

Im dargestellten Schritt G der Fig. 3e wird eine Maske 50 aufgebracht, wobei mittels der Maske (50) eine zu ätzende Kavität in der Siliziumcarbidschicht 30 bestimmt wird. Dabei kann eine kleine partielle Überlappung in die schon strukturierten Bereiche notwendig sein, um mögliche lithographische Ungenauigkeiten aufzufangen. Somit kann auf eine besonders genaue Anordnung der Maske 50 verzichtet und das hier beschriebene Herstellungsverfahren besonders zeitsparend durchgeführt werden.

Ferner wird im dargestellten Schritt G der Fig. 3f mittels der Maske 50 die Kavität K1 zumindest bereichsweise in das Halbleitersubstrat 10 geätzt, wobei das Ausbilden der Kavität K1 an einer Oberkante 6 der Ausnehmung A1 gestoppt wird, so dass die Kavität K1 mittels der Ausnehmung A1 eine Vertiefung V10 ausbildet und Seitenflächen V11 der Vertiefung V10 quer zu der Oberkante 6 verlaufen und durch die Siliziumoxidschicht 20 eine Bodenfläche V12 der Vertiefung V10 ausgebildet wird. Das Ätzen kann insbesondere durch reaktives Ionentiefenätzen (englisch: DRIE - deep reactive ion etching) durchgeführt werden. Mittels einer Massenspektroskopischen Endpunkterkennung kann das hervorstehende Oxid des Siliziumoxidwafers 20 detektiert werden und somit das Ätzen gestoppt werden. So lässt sich reproduzierbar und einfach die hier beschriebene Vertiefung V10 herstellen.

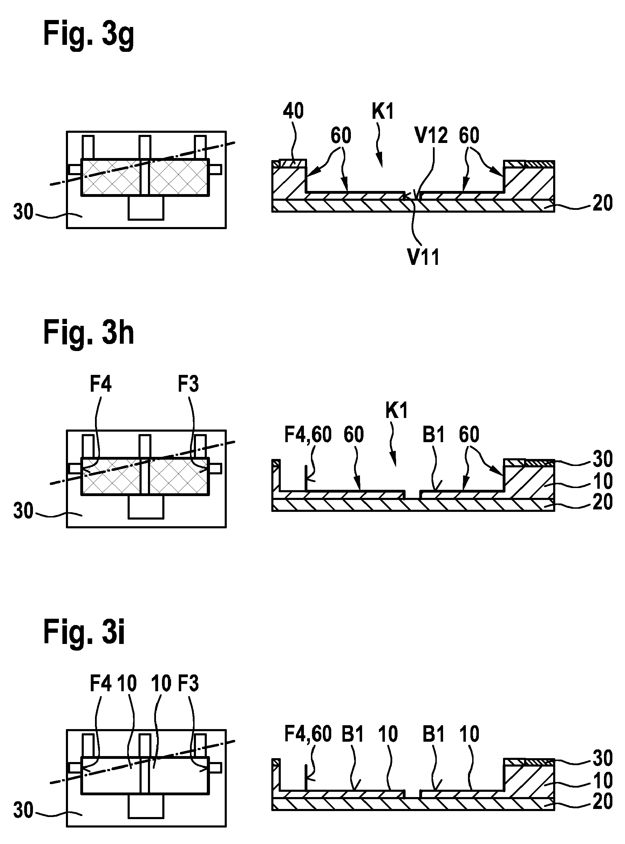

Im dargestellten Schritt der Fig. 3g wird die Maske 50 entfernt und die im Schritt G freigelegten Bereiche des Halbleitersubstrats 10 werden thermisch oxidiert (Schritt H), wobei eine weitere Siliziumoxidschicht 60 in der Kavität K1 ausgebildet wird. Hierbei kann die weitere Siliziumoxidschicht 60 eine Dicke von 1 Mikrometer umfassen.

Im dargestellten Schritt I der Fig. 3h werden die im Schritt F mit der Siliziumnitridschicht 40 bedeckten Bereiche geätzt, wobei die unter der Siliziumnitridschicht 40 befindlichen Bereiche des Halbleitersubstrats 10 derart entfernt wird, dass zumindest die im Schritt H gebildete weitere Siliziumoxidschicht 60 in Form der zwei freistehenden Seitenflächen F3, F4 der Kavität K1 ausgebildet werden. Das Ätzen kann insbesondere durch reaktives lonentiefenätzen (englisch: DRIE - deep reactive ion etching) durchgeführt werden. Hier wird beim erneuten Ätzen berücksichtigt, das der DIE Ätzschritt weder Siliziumoxid noch Siliziumcarbid mit hoher Rate ätzt, Siliziumnitrid und Silizium hingegen mit hoher Rate geätzt werden. Mit anderen Worten läuft ein materialspezifisches selektives Ätzen von Siliziumnitrid und Silizium derart schnell ab, dass insbesondere die weitere Siliziumoxidschicht 60, welches sich in der Kavität K1 homogen ausgebildet hat, bestehen bleibt. Das heißt, dass die freistehenden Seitenflächen F3, F4 mit der weiteren Siliziumoxidschicht 60 stehen bleiben.

Alternativ kann die Siliziumnitridschicht 40 nasschemisch mit Phosphorsäure selektiv gegen Siliziumoxid und Siliziumcarbid entfernt werden und anschließend der DRIE Ätzschritt zum Ätzen des Halbleitersubstrats 10, beispielsweise des Siliziums selbst, durchgeführt werden. Auch hier bleiben die freistehenden Seitenflächen F3, F4 mit der weiteren Siliziumoxidschicht 60 stehen.

Im dargestellten Schritt J der Fig. 3i wird die weitere Siliziumoxidschicht 60 an einer Bodenfläche B1 der Kavität K1 entfernt. Das Entfernen der weiteren Siliziumoxidschicht 60 an der Bodenfläche B1 der Kavität K1 kann insbesondere mittels eines gerichteten Ätzverfahrens, beispielsweise RIE(reactive ion etching), erfolgen. Um diesen Schritt zu realisieren weist die Siliziumoxidschicht 20 eine Dicke auf die insbesondere dicker ausgebildet ist als der weiteren Siliziumoxidschicht 60. Beispielsweise weist die Siliziumoxidschicht 20 eine Dicke von 2,5 Mikrometer auf, wobei die weitere Siliziumoxidschicht 60 lediglich eine Dicke von 1 Mikrometer aufweist.

Im dargestellten Schritt K der Fig. 3j werden die freistehenden Seitenflächen F3, F4 umfassend die weitere Siliziumoxidschicht 60 entfernt. Dieser Schritt kann beispielsweise mittels Flusssäuredampf realisiert werden. Die freistehenden Seitenflächen bzw. Seitenwände F3, F4 können in diesem Schritt insbesondere aus zwei Richtungen angegriffen werden. Somit liegt eine doppelt so große zu ätzende Fläche vor und die freistehenden Seitenflächen F3, F4 werden um ein vielfaches schneller durch das Ätzmedium entfernt als beispielsweise das Siliziumoxid der ersten Seitenflächen F1 und der zweiten Seitenfläche F2 oder das in der Vertiefung V10 befindliche Siliziumoxid der weiteren Siliziumoxidschicht 60. Das Siliziumoxid des Halbleitersubstrats 10 der hier beschriebenen Stromzuführbereiche S1, S2 und Hallspannungsbereiche UH1, UH2 sowie die Siliziumoxidschicht 20 werden teilweise geätzt aber nicht vollständig entfernt.

Im dargestellten Schritt L der Fig. 3k werden insbesondere auf die hier beschriebenen freigelegten Siliziumoxidbereiche der entsprechenden Siliziumoxidschichten 10, 20, 60 selektiv eine homogene Kohlenstoffschicht abgeschieden. Das heißt, dass auf durch die vorangegangen Schritte freigelegten Flächen aus dem Siliziumoxid die homogene Kohlenstoffschicht aufgewachsen wird.

Ferner wird eine elektrisch isolierende Siliziumcarbidschicht 80 auf entsprechend freigelegte Flächen des Halbleitersubstrats 10 abgeschieden, wobei zwischen den zwei Hallspannungsbereichen UH1, UH2 mittels der selektiv abgeschiedenen homogenen Kohlenstoffschicht 70 und der Ausnehmung A1 oder Vertiefung V10 eine Verbindung hergestellt wird und die zwei Stromzuführbereiche S1, S2 durch die im Schritt K bereichsweise entfernten Seitenflächen F3, F4 über die Seitenflächen F3 und F4 keinen elektrischen Kontakt zur Seitenfläche F2 aufweisen.

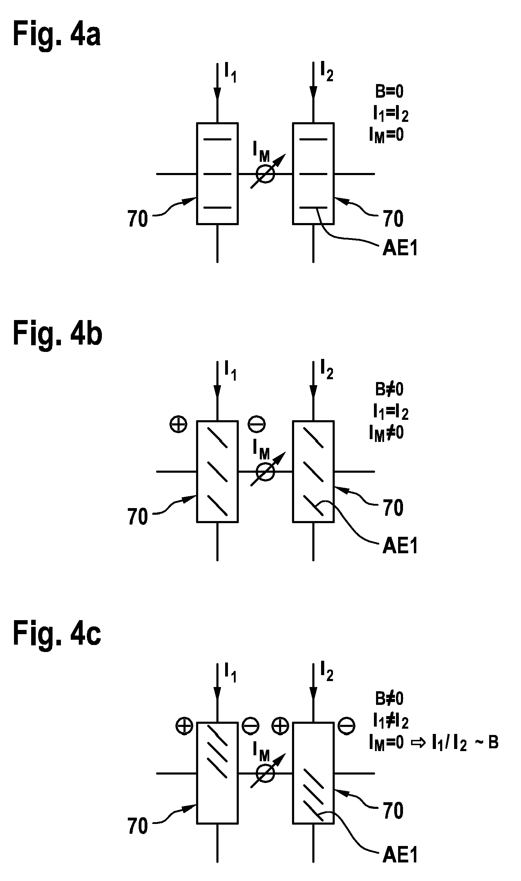

Fig. 4a bis 4c zeigen schematische Darstellungen eines Auswerteverfahrens.

Ein Auswerteverfahren für die Sensorvorrichtung basiert auf einer reinen Betrachtung von elektrischen Strömen, welche Erhaltungsgrößen sind. So lässt sich die hier beschriebene Sensorvorrichtung relativ rauscharm auslesen. Für diese Art sind jeweils zwei Sensorvorrichtungen miteinander verschaltet, wie in Fig. 4a skizziert. Das Rechteck repräsentiert die aktive Kohlenstoffschicht bzw. Kohlenstoffoberfläche 70 eines der beiden verschalteten Sensorvorrichtungen. Die Kontakte, Zuleitung für den Strom durch die Sensorvorrichtung sind durch die Striche an den kurzen Seiten des Rechtecks skizziert. Der Hall-Effekt wird jeweils an einer Sensormitte, das heißt die Mitte der langen Rechteckseite abgegriffen und der Strom dieser Verbindung zwischen den beiden gemessen bzw. abgeglichen. Die beiden Sensorvorrichtungen werden jeweils mit dem Strom I₁ bzw. b gespeist. Der Ausgang der Sensorvorrichtungen liegt auf dem gleichen Potential.

Im Fall, dass kein Magnetfeld senkrecht zur Kohlenstoffschicht 70 anliegt, kommt es zu keiner Verkippung der Äquipotentiallinien innerhalb der einzelnen Sensorvorrichtung. Ist der Strom I₁ und I₂ gleich, so fließt, wie in Fig. 4a gezeigt, kein Strom I_{M} zwischen den beiden Sensorvorrichtungen.

In einem Magnetfeld, kommt es aufgrund des Hall-Effekts zu einer Verkippung der Äquipotentiallinien. Sind die beiden Ströme I₁ und I₂ gleich, so fließt ein Strom I_{M} zwischen den beiden Sensorvorrichtungen, siehe Fig. 4b. Eine Möglichkeit um die Messung zu verbessern, kann darin gesehen werden, den Strom I_{M} in einem Feedback-Loop auf Null zu setzen, und zwar durch das Anpassen des Verhältnisses der beiden Eingangsströme I₁ durch I₂, siehe Fig. 4c. Damit ist dieses Verhältnis ein Maß für das Magnetfeld geworden und kann für dessen Bestimmung verwendet werden.

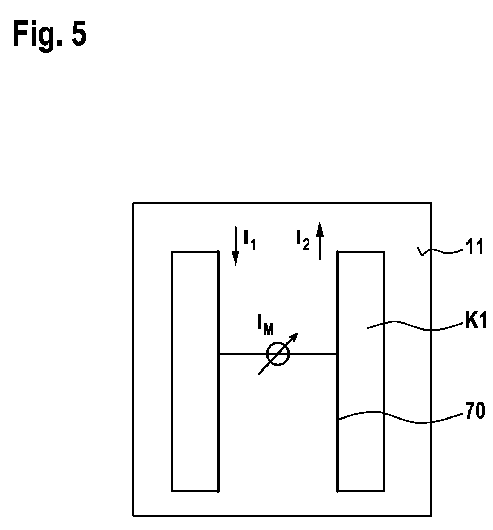

Fig. 5 zeigt eine schematische Darstellung eines alternativen Auswerteverfahrens

Die beiden Sensorvorrichtungen können planar nebeneinander auf der Vorderseite 11 des Halbleitersubstrats 10 ausgeführt werden. Oder aber wie auch im oben beschriebenen Verfahren an eine Seitenwand der Kavität K1 integriert werden. Dabei kann je nach gewählter, paralleler Seitenwand F1, F2 die Stromrichtung der Einspeisung in die Sensorvorrichtung angepasst werden, wie in Fig. 5 skizziert.

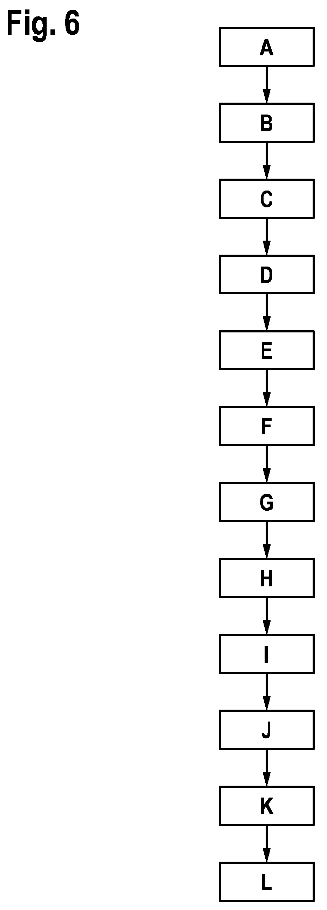

Fig. 6 zeigt ein Flussdiagramm zum Erläutern eines Herstellungsverfahrens für eine Sensorvorrichtung gemäß einer Ausführungsform der vorliegenden Erfindung.

Die Verfahrensschritte A bis L können insbesondere in der hier beschriebenen Reihenfolge ablaufen.

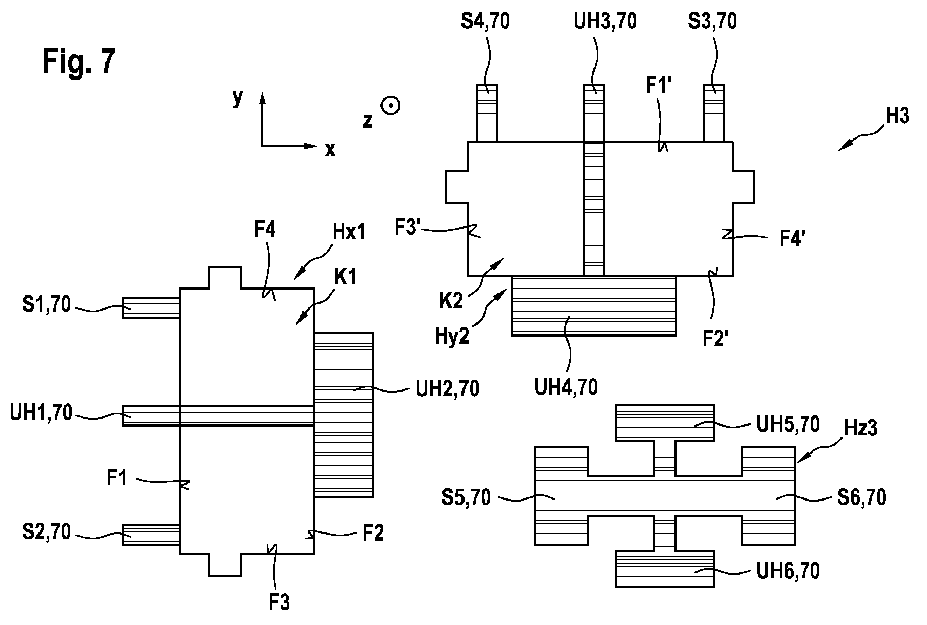

Fig. 7 zeigt eine schematische Aufsicht zum Erläutern einer dreidimensionalen Sensorvorrichtung gemäß einer Ausführungsform der vorliegenden Erfindung.

In Fig 7 bezeichnen jeweils Bezugszeichen Hx1, Hy2 und Hz3 Sensorvorrichtungen der dreidimensionalen Sensorvorrichtung H3, wobei die zwei Sensorvorrichtungen Hx1, Hy2 derart orthogonal zueinander verschaltet sind, dass Magnetfelder in X-Richtung und Y-Richtung messbar sind. Ferner umfasst die dreidimensionale Sensorvorrichtung H3 eine dritte Sensorvorrichtung Hz3, die auf der Oberseite O1 der ersten Sensorvorrichtung Hx1 angeordnet sein kann, so dass mit der dritten Sensorvorrichtung Hz3 ein Magnetfeld in Z-Richtung messbar ist. Das heißt, dass die dreidimensionale Sensorvorrichtung H3 die erste Hx1, zweite Hy2 und dritte Sensorvorrichtung Hz3 umfasst.

Der Aufbau der zweiten Sensorvorrichtung Hy2 basiert auf dem Aufbau der Sensorvorrichtung Hx1 der Fig. 1a und 1b, wobei die zweite Sensorvorrichtung Hy2 um 90° zu der ersten Sensorvorrichtung Hx1 in Bezug auf ein orthogonales Koordinatensystem gedreht ist. Somit umfasst die zweite Sensorvorrichtung Hy2 entsprechend die zwei Stromzuführbereiche S3, S4 und einen ersten Hallspannungsbereich UH3, wobei der erste Hallspannungsbereich UH3 zwischen den zwei Stromzuführbereichen S1, S2 der zweiten Sensorvorrichtung Hy2 angeordnet ist und der zweite Hallspannungsbereich UH4 dem ersten Hallspannungsbereich UH3 gegenüberliegt. Eine Kavität K2 der zweiten Sensorvorrichtung Hy2 weist entsprechend die Seitenflächen F1', F2', F3' und F4' auf.

Eine homogene Kohlenstoffschicht 70 der dritten Seitenfläche F3' und der vierten Seitenfläche F4' ist durchbrochen und der erste Hallspannungsbereich UH3 ist mit dem zweiten Hallspannungsbereich UH4 der zweiten Sensorvorrichtung Hy2 mittels der homogenen Kohlenstoffschicht 70 verbunden, wobei die Ausnehmung A1 als Kontaktbrücke fungiert.

Die dritte Sensoranordnung Hz3 zum Messen des Magnetfeldes in Z-Richtung kann an der Oberfläche O1 der ersten bzw. zweiten Sensorvorrichtung angeordnet sein. Die dritte Sensoranordnung Hz3 umfasst zwei Hallspannungsbereiche UH5, UH6 sowie zwei Stromzuführbereiche S5, S6.

Die hier beschriebenen Merkmale der Sensorvorrichtung gelten ebenfalls für die dreidimensionale Sensorvorrichtung als auch für das hier beschriebene Herstellungsverfahren sowie umgekehrt.

Obwohl die vorliegende Erfindung anhand bevorzugter Ausführungsbeispiele beschrieben wurde, ist sie darauf nicht beschränkt. Insbesondere sind die genannten Materialien und Topologien nur beispielhaft und nicht auf die erläuterten Beispiele beschränkt.

## Patentansprüche

1. Sensorvorrichtung (Hx1) zum Messen eines Magnetfeldes mit
einem Halbleitersubstrat (10), das eine Kavität (K1) umfasst;
wobei die Kavität (K1) eine Oberseite (O1), eine Bodenfläche (B1), eine erste Seitenfläche (F1), eine zweite Seitenfläche (F2), eine dritte Seitenfläche (F3) und eine vierte Seitenfläche (F4) umfasst, wobei die erste Seitenfläche (F1) der zweiten Seitenfläche (F2) gegenüberliegt und die dritte Seitenfläche (F3) der vierten Seitenfläche (F4) gegenüberliegt;
wobei die Oberseite (O1) der Kavität (K1) an der ersten Seitenfläche (F1) zumindest bereichsweise zwei Stromzuführbereiche (S1, S2) und einen ersten Hallspannungsbereich (UH1) aufweist, wobei der erste Hallspannungsbereich (UH1) zwischen den zwei Stromzuführbereichen (S1, S2) angeordnet ist; und wobei an der Oberseite (O1) der zweiten Seitenfläche (F2) ein zweiter Hallspannungsbereich (UH2) angeordnet ist; und
wobei die Bodenfläche (B1) der Kavität (K1) eine Ausnehmung (A1) aufweist, die zwischen der ersten Seitenfläche (F1) und der zweiten Seitenfläche (F2) durchgehend ausgebildet ist; und
wobei die erste, zweite, dritte und vierte Seitenflächen (F1, F2, F3, F4), die Ausnehmung (A1), die zwei Stromzuführbereiche (S1, S2), der erste Hallspannungsbereich (UH1) und der zweite Hallspannungsbereich (UH2) eine zumindest bereichsweise homogene Kohlenstoffschicht (70) aufweisen; und
wobei die zumindest bereichsweise homogene Kohlenstoffschicht (70) der dritten Seitenfläche (F3) und der vierten Seitenfläche (F4) durchbrochen ist und der ersten Hallspannungsbereich (UH1) mit dem zweiten Hallspannungsbereich (UH2) mittels der zumindest bereichsweisen homogenen Kohlenstoffschicht (70) verbunden ist.

2. Sensorvorrichtung (Hx1) nach Anspruch 1, wobei die homogene Kohlenstoffschicht (70) ein ausschließlich auf Siliziumoxid selektiv aufwachsbares Graphen umfasst.

3. Sensorvorrichtung (Hx1) nach einem der vorherigen Ansprüche, wobei auf Flächen der Sensorvorrichtung (Hx1), die frei von der homogen Kohlenstoffschicht (70) sind, zumindest bereichsweise Siliziumcarbid (30, 80) aufgewachsen sind.

4. Dreidimensionale Sensorvorrichtung (H3) mit zwei Sensorvorrichtungen (Hx1, Hy2) nach Anspruch 1, wobei die zwei Sensorvorrichtungen (Hx1, Hy2) derart orthogonal zueinander auf Waferlevel verschaltet sind, dass Magnetfelder in X-Richtung und Y-Richtung (Hy2) messbar sind, sowie eine die homogenen Kohlenstoffschicht (70) umfassende dritte Sensorvorrichtung (Hz3), die auf der Oberseite (O1) angeordnet ist und mit der dritten Sensorvorrichtung (Hz3) ein Magnetfeld in Z-Richtung messbar ist.

5. Herstellungsverfahren für eine Sensorvorrichtung (Hx1) mit den Schritten:
A) Bereitstellen eines Halbleitersubstrats (10) mit einer Vorderseite (11) und einer Rückseite (12), wobei auf der Rückseite (12) des Halbleitersubstrats (10) eine Ausnehmung (A1) angeordnet ist;
B) Bereitstellen einer Siliziumoxidschicht (20), wobei das Halbleitersubstrat (10) mit der Rückseite (12) auf die Siliziumoxidschicht (20) angeordnet und die Ausnehmung (A1) bedeckt wird;
C) Thermisches Oxidieren des Halbleitersubstrats (10) zum Ausbilden einer Siliziumoxidschicht (1) und Strukturieren der Siliziumoxidschicht (1) zum Ausbilden von zwei Stromzuführbereichen (S1, S2) und von zwei Hallspannungsbereiche (UH1, UH2) zur Inbetriebnahme der Sensorvorrichtung (Hx1) nach Schritt L;
D) Ganzflächiges Aufbringen einer Siliziumcarbidschicht (30) auf einer der Rückseite (12) des Halbleitersubstrats (10) abgewandten Fläche;
E) Strukturieren der Siliziumcarbidschicht (30) derart, dass miteinander elektrisch in Kontakt stehenden Seitenfläche (F3, F4) nach Schritt K getrennt werden, wobei das Halbleitersubstrat (10) zumindest bereichsweise freigelegt wird;
F) Ganzflächiges Abscheiden und anschließendes Strukturieren einer Siliziumnitridschicht (40), so dass die zumindest bereichsweise freiliegenden Flächen des Halbleitersubstrats (10) mit der Siliziumnitridschicht (40) bedeckt werden;
G) Aufbringen einer Maske (50), wobei mittels der Maske (50) eine zu ätzende Kavität in der Siliziumcarbidschicht 30 bestimmt wird und mittels der Maske (50) die Kavität (K1) zumindest bereichsweise in das Halbleitersubstrat (10) geätzt wird, wobei das Ausbilden der Kavität (K1) an einer Oberkante (6) der Ausnehmung (A1) gestoppt wird, so dass die Kavität (K1) mittels der Ausnehmung (A1) eine Vertiefung (V10) ausbildet und Seitenflächen (V11) der Vertiefung (V10) quer zu der Oberkante (6) verlaufen und durch die Siliziumoxidschicht (20) eine Bodenfläche (V12) der Vertiefung (V10) ausgebildet wird und anschließend die Maske entfernt wird;
H) Thermisches Oxidieren der im Schritt G freigelegten Bereiche des Halbleitersubstrats (10), wobei eine weitere Siliziumoxidschicht (60) in der Kavität (K1) ausgebildet wird;
I) Ätzen der im Schritt F mit der Siliziumnitridschicht (40) bedeckten Bereiche, wobei die unter der Siliziumnitridschicht (40) befindlichen Bereiche des Halbleitersubstrats (10) derart entfernt wird, dass zumindest die im Schritt H gebildete weitere Siliziumoxidschicht (60) in Form der zwei freistehenden Seitenflächen (F3, F4) der Kavität (K1) ausgebildet werden;
J) Entfernen der weiteren Siliziumoxidschicht (60) an einer Bodenfläche (B1) der Kavität (K1);
K) Bereichsweises Entfernen der freistehenden Seitenflächen (F3, F4) umfassend die weitere Siliziumoxidschicht (60);
L) Selektives Abscheiden einer homogenen Kohlenstoffschicht (70) auf durch die vorangegangen Schritte freigelegten Flächen aus dem Siliziumoxid (10, 20, 60) und Abscheiden einer elektrisch isolierenden Siliziumcarbidschicht (80) auf entsprechend freigelegten Flächen des Halbleitersubstrats (10), wobei zwischen den zwei Hallspannungsbereichen (UH1, UH2) mittels der selektiv abgeschiedenen homogenen Kohlenstoffschicht (70) und der Ausnehmung (A1) eine Verbindung hergestellt wird und die zwei Stromzuführbereiche (S1, S2) durch die im Schritt K bereichsweise entfernten Seitenflächen (F3, F4) zu der Seitenfläche (F2) elektrisch isoliert sind.

6. Herstellungsverfahren nach Anspruch 5, wobei mittels einer Schattenmaske Metallkontakte zum Kontaktieren der Stromzuführbereiche (S1, S2) angeordnet werden.

7. Herstellungsverfahren nach Anspruch 5, wobei die Siliziumoxidschicht (1) eine Dicke von 2,5 Mikrometer umfasst.

8. Herstellungsverfahren nach Anspruch 5, wobei die Siliziumcarbidschicht (30) aus Schritt C eine Dicke von 500 Nanometer umfasst.

9. Herstellungsverfahren nach Anspruch 5, wobei die Siliziumnitridschicht (40) aus Schritt F eine Dicke von 300 Nanometer umfasst.

10. Herstellungsverfahren nach Anspruch 5, wobei die homogene Kohlenstoffschicht (70) ein selektiv ausschließlich an Siliziumoxid aufwachsendes Graphen umfasst.

11. Herstellungsverfahren nach Anspruch 5, wobei die weitere Siliziumoxidschicht (60) der Kavität (K1) eine Dicke von 1 Mikrometer umfasst.

12. Herstellungsverfahren nach Anspruch 5, wobei das Ätzen mittels reaktiven Ionentiefätzens durchgeführt wird.
